# DEMANDE DE BREVET EUROPEEN

(11) **EP 2 333 825 A2**
(43) Date de publication de la demande: **15.06.2011**
(21) Numéro de dépôt: 10194234.0
(22) Date de dépôt: 08.12.2010
(51) Int. Cl.: H01L 21/768, H01L 23/48

(54) **Dispositif microélectronique intégré avec liaisons traversantes.**

(30) Priorité: 10.12.2009 FR 0958852
(71) Demandeur: STMicroelectronics (Crolles 2) SAS, 38920 Crolles (FR)
(72) Inventeur: Farcy, Alexis, 73490, La Ravoire (FR); Rousseau, Maxime, 38000, Grenoble (FR)
(74) Mandataire: Zapalowicz, Francis

(57) **Abrégé**

Dispositif microélectronique intégré comprenant un substrat (1) présentant une première face et une deuxième face, au moins un composant (3) situé sur la première face et possédant une zone active dopée (2) dans le substrat, au moins une liaison traversante (4) électriquement conductrice reliant la deuxième face à la première face, et électriquement isolée du substrat (1) par une couche isolante. Le dispositif comprend une zone tampon (9) située entre ladite couche isolante et ladite zone active dopée (2), différente de la couche isolante et de la zone active dopée, et agencée de façon à réduire le couplage électrique entre la liaison traversante (4) électriquement conductrice et la zone active dopée (2).

## Description

L'invention concerne le domaine des dispositifs microélectroniques et plus particulièrement le couplage électrique dans les dispositifs microélectroniques comprenant au moins une liaison traversante électriquement conductrice, communément désignée par l'homme du métier sous la dénomination anglosaxonne de « Through Silicon Vias (TSV) ».

L'intégration des dispositifs microélectroniques est un défi majeur compte tenu des enjeux commerciaux liés aux nouvelles technologies. L'intégration passe classiquement par une réduction de la taille des transistors, brique élémentaire de la plupart des dispositifs microélectroniques. Cependant la réduction de taille des composants atteint ses limites, les effets quantiques liés à la réduction de taille devenant prépondérants et difficilement contrôlables avec les technologies actuelles. Aussi, une autre voie d'intégration explorée, comprend la réalisation de composants actifs sur les deux faces d'un substrat afin d'en augmenter la densité surfacique. Pour faire communiquer les composants de deux faces, il est nécessaire de faire appel à des liaisons traversantes électriquement conductrices, et reliant les deux faces du substrat.

Une autre application des liaisons traversantes réside dans l'interconnexion de circuits intégrés empilés.

Les liaisons traversantes peuvent permettre également de connecter des composants situés sur une face du substrat à des billes de connexion (« bumps » en langue anglaise) disposées de l'autre côté du substrat.

Bien que les liaisons traversantes soient électriquement isolées, un couplage électrique peut apparaître avec les composants actifs présents à proximité, dégradant alors les performances.

Selon un mode de réalisation, il est proposé un dispositif microélectronique intégré comprenant un couplage électrique réduit au voisinage des liaisons traversantes, permettant ainsi une interconnexion plus efficace entre différentes puces.

Selon un aspect, il est proposé un dispositif microélectronique intégré comprenant un substrat présentant une première face et une deuxième face, au moins un composant situé sur la première face et possédant une zone active dopée dans le substrat, au moins une liaison traversante électriquement conductrice reliant la deuxième face à la première face, et électriquement isolée du substrat par une couche isolante; selon une caractéristique générale de cet aspect, le dispositif comprend une zone tampon située entre ladite couche isolante et ladite zone active dopée, différente de la couche isolante et de la zone active dopée, et agencée de façon à réduire le couplage électrique entre la liaison traversante électriquement conductrice et la zone active dopée.

La zone active dopée est préférentiellement plus conductrice que le substrat et ledit au moins un composant est réalisé dans et sur cette zone active.

Selon un mode de réalisation, la zone tampon peut être avantageusement une couche conductrice disposée entre la couche isolante de la liaison traversante et la zone active dopée du substrat. De plus, la zone tampon peut être au contact de cette couche isolante et de cette zone active dopée.

La zone tampon peut être une zone moins conductrice, par exemple moins dopée, que la zone active dopée.

La zone tampon peut être une partie du substrat.

La zone tampon peut s'étendre sur une profondeur au moins égale à l'épaisseur de la zone active dopée.

Le dispositif peut comprendre en outre une zone d'isolation du type tranchée peu profonde (communément désignée par l'homme du métier sous la dénomination anglosaxonne de « Shallow Trench Insulation » (STI »)), entre le composant et la couche isolante, la zone tampon s'étendant sous la zone d'isolation peu profonde.

Le substrat peut être en outre configuré pour être électriquement couplé avec la masse. Ceci permet de réduire encore davantage le couplage électrique, ce qui est particulièrement intéressant pour les applications radiofréquence.

Le dispositif peut ainsi par exemple comprendre une couche de redistribution destinée à être couplée à la masse, et électriquement couplée avec le substrat par l'intermédiaire d'au moins un contact.

D'autres buts, caractéristiques et avantages apparaîtront à la lecture de la description suivante donnée uniquement en tant qu'exemple non limitatif et faite en référence aux dessins annexés sur lesquels :
- la figure 1 illustre les principaux éléments d'un dispositif électronique comprenant une liaison traversante, selon l'état de la technique;
- la figure 2 illustre les principaux éléments d'un dispositif électronique comprenant une liaison traversante, selon un mode de réalisation de l'invention; et
- la figure 3 illustre les principaux éléments d'un dispositif électronique comprenant une liaison traversante, selon un autre mode de réalisation de l'invention.

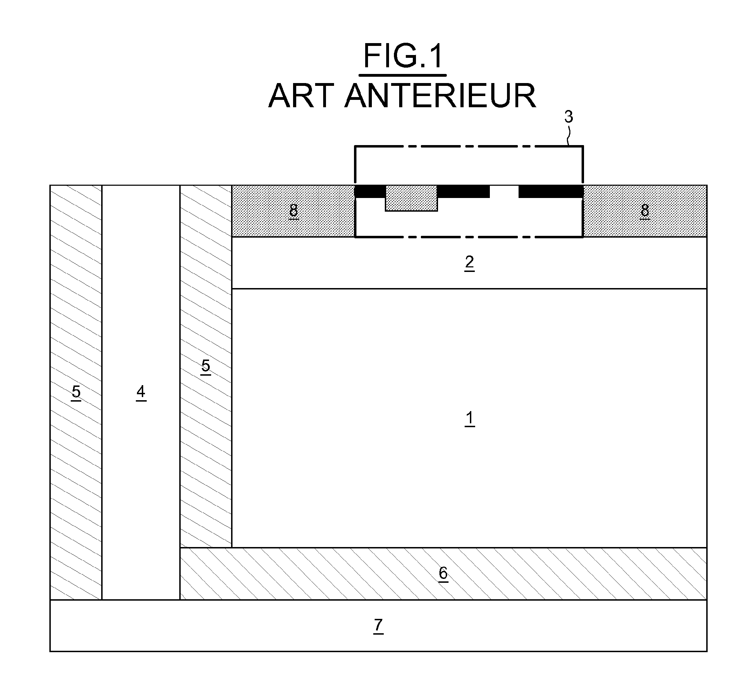

Sur la figure 1, le dispositif microélectronique intégré comprend un substrat 1, par exemple un substrat massif ou bien aminci dopé P⁻. Sur sa face inférieure, le substrat 1 peut être isolé électriquement de l'environnement par une couche d'isolation inférieure 6. Au voisinage de la face supérieure, le substrat comprend une zone active dopée 2 dont la concentration de dopants est supérieure à la concentration de dopants du substrat 1.

Un composant 3 est réalisé dans et sur cette zone active dopée 2. Le composant 3 peut être un transistor comprenant une région de source, une région de drain et une grille. Bien qu'un seul composant 3 soit représenté sur la figure 1, d'autres composants peuvent être présents sur la surface du substrat 1. Afin de séparer deux composants adjacents, il est usuel d'employer des tranchées d'isolation peu profondes 8 (STI).

Pour permettre d'accéder à la face inférieure du composant, par exemple pour permettre une connexion à des billes de connexion (« bumps »), ou pour permettre une interconnexion électrique entre différentes puces ou circuits intégrés empilés, on a alors recours à des liaisons traversantes 4 électriquement conductrices. Sur la figure 1, on peut voir une liaison traversante 4 reliant la face avant du dispositif à sa face arrière. Afin d'isoler électriquement la liaison traversante 4 du substrat 1 et/ou de la zone active dopée 2, une couche d'isolation 5, par exemple un oxyde, est prévue autour de la liaison traversante 4. Le substrat 1 peut également comporter en face arrière une autre couche conductrice, par exemple une couche de redistribution, destinée à être reliée par exemple à la masse.

En fonctionnement, un couplage électrique se forme entre la liaison traversante 4 et à la fois la zone active dopée 2 et le substrat 1. La zone active dopée 2 étant plus conductrice que le substrat 1 du fait du dopage, le couplage est alors plus important entre la liaison traversante 4 et la zone active dopée 2 qu'entre la liaison traversante 4 et le substrat. Le couplage électrique crée un bruit électronique préjudiciable au fonctionnement du composant 3.

A cause des contraintes d'intégration et du budget thermique des étapes ultérieures, il n'est pas possible de recourir à un blindage métallique traditionnel.

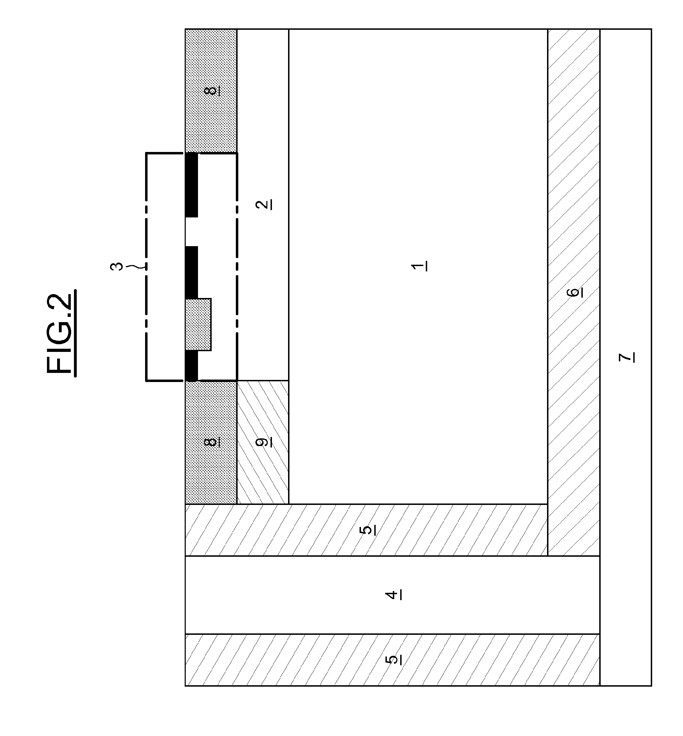

La figure 2 illustre un exemple de dispositif similaire au dispositif illustré dans la figure 1 mais offrant une réduction du couplage électrique. A cet effet, une zone tampon 9 est formée entre la liaison traversante 4 et la zone active dopée 2 afin de les découpler électriquement.

La zone tampon 9 est formée par un matériau plus isolant que la zone active dopée 2. La zone tampon 9 peut être aussi une partie du substrat 1. La zone tampon 9 permet la dissipation de l'onde de couplage entre la liaison traversante 4 et la zone active dopée 2.

Dans cet exemple, la zone tampon 9 s'étend sous la tranchée d'isolation 8 sur une profondeur égale à celle de la zone active dopée. En pratique, cette zone tampon qui est ici une partie du substrat 1, peut être obtenue en ne dopant pas cette zone lors de la réalisation de la zone active dopée. Cela étant, une autre solution pourrait consister en l'intégration de la zone tampon 9 sans la présence de tranchées d'isolation peu profondes 8.

Il est ainsi possible d'obtenir une réduction du couplage électrique de l'ordre de 50% par rapport à un dispositif de l'état de la technique.

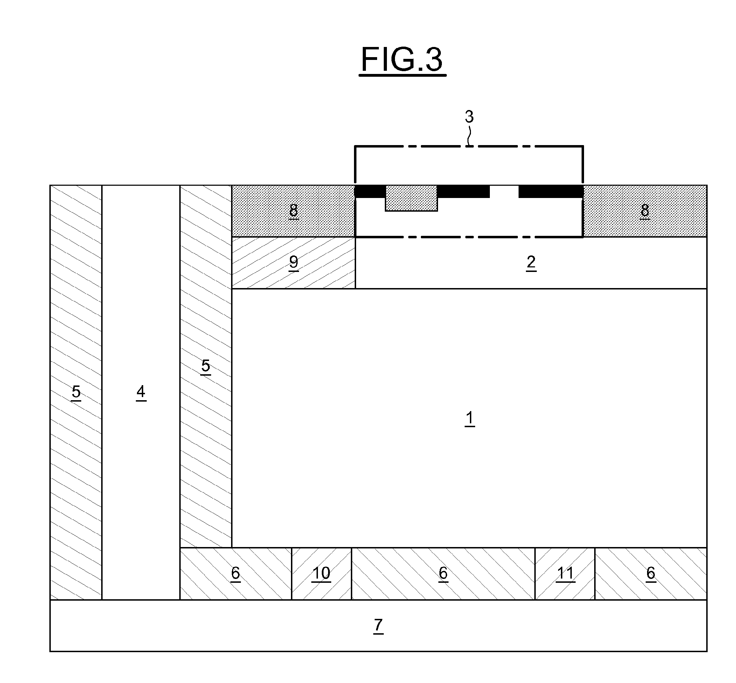

La figure 3 illustre un autre mode de réalisation, dans lequel le dispositif comprend en plus une connexion à la couche de redistribution 7 reliée à la masse. La connexion peut être réalisée par un contact continu ou discret (10,11) entre le substrat 1 et la couche de redistribution 7. Les contacts peuvent être réalisés en cuivre ou en tungstène afin de combiner un bon contact et une faible différence de travail de sortie entre le substrat 1 et les connexions (10,11).

Les connexions (10,11) à la couche de redistribution 7 permettent l'absorption et la canalisation de l'onde de couplage émise au voisinage de la liaison traversante 4. Le couplage entre la liaison traversante 4 et la zone active dopée 2 est ainsi encore réduit au profit d'un couplage entre la liaison traversante 4 et la couche de redistribution 7.

La zone tampon et la connexion du substrat à la masse peuvent être utilisées séparément ou combinées afin d'obtenir une protection envers le couplage électrique encore plus importante. Aussi dans le cas de la figure 3, qui combine une zone tampon 9 et une connexion du substrat à la masse, on peut obtenir une réduction supplémentaire du couplage électrique de l'ordre de 30%.

L'invention peut être appliquée à toutes les technologies tirant profit d'une liaison traversante, par exemple les technologies de capteurs d'image, notamment les capteurs d'image avec illumination en face arrière, les technologies de radiofréquence et d'ondes millimétriques et les technologies microélectroniques tridimensionnelles.

## Revendications

1. Dispositif microélectronique intégré comprenant un substrat (1) présentant une première face et une deuxième face, au moins un composant (3) situé sur la première face et possédant une zone active dopée (2) dans le substrat (1), au moins une liaison traversante (4) électriquement conductrice reliant la deuxième face à la première face, et électriquement isolée du substrat (1) par une couche isolante (5), **caractérisé en ce qu'**il comprend une zone tampon (9) située entre ladite couche isolante (5) et ladite zone active dopée (2), différente de la couche isolante (5) et de la zone active dopée (2), et agencée de façon à réduire le couplage électrique entre la liaison traversante (4) électriquement conductrice et la zone active dopée (2).

2. Dispositif selon la revendication 1, dans lequel la zone tampon (9) est une zone moins conductrice que la zone active dopée (2).

3. Dispositif selon l'une quelconque des revendications précédentes, dans lequel la zone tampon (9) est une partie du substrat (1).

4. Dispositif selon l'une quelconque des revendications précédentes, dans lequel la zone tampon (9) s'étend sur une profondeur au moins égale à l'épaisseur de la zone active dopée (2).

5. Dispositif selon l'une quelconque des revendications précédentes, comprenant en outre une zone d'isolation du type tranchée peu profonde (8) entre le composant (3) et la couche isolante (5), la zone tampon (9) s'étendant sous la zone d'isolation peu profonde (8).

6. Dispositif selon l'une des revendications précédentes, dans lequel le substrat (1) est en outre configuré pour être électriquement couplé avec la masse.

7. Dispositif selon la revendication 6, comprenant une couche de redistribution (7) destinée à être couplée à la masse, et électriquement couplée avec le substrat (1) par l'intermédiaire d'au moins un contact (10).
